Europäisches Patentamt

(19) European Patent Office

Office européen des brevets

(11) Publication number: **0 219 266**
**B1**

(12) EUROPEAN PATENT SPECIFICATION

(45) Date of publication of the patent specification:
26.09.90

(51) Int. Cl.⁵: **G01R 31/12**

(21) Application number: 86307528.9

(22) Date of filing: 01.10.86

(54) Method for evaluating the breakdown time of an insulating film.

(30) Priority: 02.10.85 JP 219848/85

(43) Date of publication of application:
22.04.87 Bulletin 87/17

(45) Publication of the grant of the patent:
26.09.90 Bulletin 90/39

(84) Designated Contracting States:
DE GB

(56) References cited:
IEEE 19th ANNUAL PROCEEDINGS, RELIABILITY
PHYSICS, San Francisco, California, 1981,
pages 204-209, IEEE/Proc. IRPS; A. BERMAN:
"Time-zero dielectric reliability test by a ramp method"
IEEE 17th ANNUAL PROCEEDINGS, RELIABILITY
PHYSICS, San Francisco, California, 1979, pages 1-7,
IEEE, US; D.L. CROOK ; "Method of determining
reliability screens for time dependent dielectric
breakdown"
IEEE 17th ANNUAL PROCEEDINGS, RELIABILITY
PHYSICS, San Francisco , California, 1979, pages 8-12,
IEEE, US; E.S. ANOLICK: "Low field time dependent
dielectric integrity"
IBM TECHNICAL DISCLOSURE BULLETIN, vol. 28, no. 5,
October 1985, pages 2138-2139, New York, US:
"Breakdown voltage measurement of thin insulator
films by current ramping technique"

(73) Proprietor: SEIKO INSTRUMENTS INC., 31-1,
Kameido 6-chome Koto-ku, Tokyo 136(JP)

(72) Inventor: Hirai, Yoshio, 31-1, Kameido 6-chome, Koto-ku
Tokyo(JP)

(74) Representative: Miller, Joseph et al, J. MILLER & CO.
Lincoln House 296-302 High Holborn, London
WC1V 7JH(GB)

## Description

The present invention relates to a method for evaluating the breakdown time of an insulating film.

Previously suggested techniques for evaluating the breakdown time of an insulating film include a "voltage ramping" method and a "Time Dependent Dielectric Breakdown" (TDDB) method.

According to the "voltage ramping" method, a voltage applied to the film is gradually increased in order to measure either the voltage or the electric field when the current through the film has exceeded a predetermined value. According to the TDDB method, a constant voltage is continuously applied to the insulating film, or a constant current is caused to flow through the insulating film, and the time at which the insulating film breaks down is measured.

The above-mentioned methods are disclosed in the following papers:-

A. Berman, "Time-zero dielectric reliability test by a ramp method," IEEE/IRPS, pp 204-209, 1981.

D.L. Crook, "Method of determining reliability screens for time dependent dielectric breakdown," IEEE/IRPS, pp 1-7, 1979.

Progress in the materials and equipment employed in recent years, however, has contributed to improve the quality of the insulating films so that the number of pinholes and weak spots is much reduced. Consequently, the "voltage ramping" method is no longer capable of producing good results, and it is becoming difficult to get an exact comparison between the insulating properties of different insulating films.

In recent years, a constant-voltage TDDB system has been introduced which is capable of measuring many points on a film simultaneously, but this constantvoltage TDDB system has not been able to detect the total electric charge that passed through the film. A constant-current TDDB system, on the other hand, is capable of easily detecting the total electric charge, but, in the case of such a constant-current TDDB system it is quite difficult to measure a number of points on a film simultaneously and consequently the constantcurrent TDDB system requires a greatly extended period of time.

According to the present invention, there is provided a method for evaluating the breakdown time of an insulating film comprising causing a current to flow through said film characterised by determining the distribution of the breakdown current density in the film, making a correlation between the said distribution and the mean time between failures of a constant-current Time Dependent Dielectric Breakdown, and finding the breakdown time of said insulating film by means of said correlation.

The current may be caused to flow by applying a gradually increased voltage to the film. In this case, the breakdown current density may be deduced by monitoring the current through the insulating film so as to determine the point at which the current is about to increase abruptly.

Alternatively, the current may be gradually increased in a logarithmic manner. In this case, the breakdown current density may be deduced by monitoring the voltage of the film so as to determine the point at which the voltage is about to decrease abruptly.

The invention is illustrated, merely by way of example, in the accompanying drawings, in which:

Figures 1(a) and 1(b) are diagrams illustrating the use of a "voltage ramping" method in the present invention;

Figures 2(a) and 2(b) are diagrams illustrating the use of a "current ramping" method in the present invention;

Figure 3 is a diagram showing the variations in the insulating strength of various films as determined by the "voltage ramping" method, the term "breakdown events" in this Figure indicating the frequency of the breakdown, while $E_{ox}$ indicates the electrical field strength of the film;

Figure 4 is a diagram showing the variation of the insulating strength of various films as determined by a constant-current TDDB method, the term "Cumulative Failure" in this Figure indicating the cumulative failure rate up to a certain electrical field;

Figure 5 is a diagram showing distributions of breakdown current densities of various films when examined by the method of the present invention;

Figure 6 is a diagram showing a correlation between the distributions of breakdown current densities (BCDD) which is used in the case of the present invention and the constant-current TDDB which is used in a known method; and

Figure 7 is a diagram showing a constant-current TDDB which is deduced from the distributions of breakdown current densities (BCDD) by the present invention in comparison with a measured constant-current TDDB.

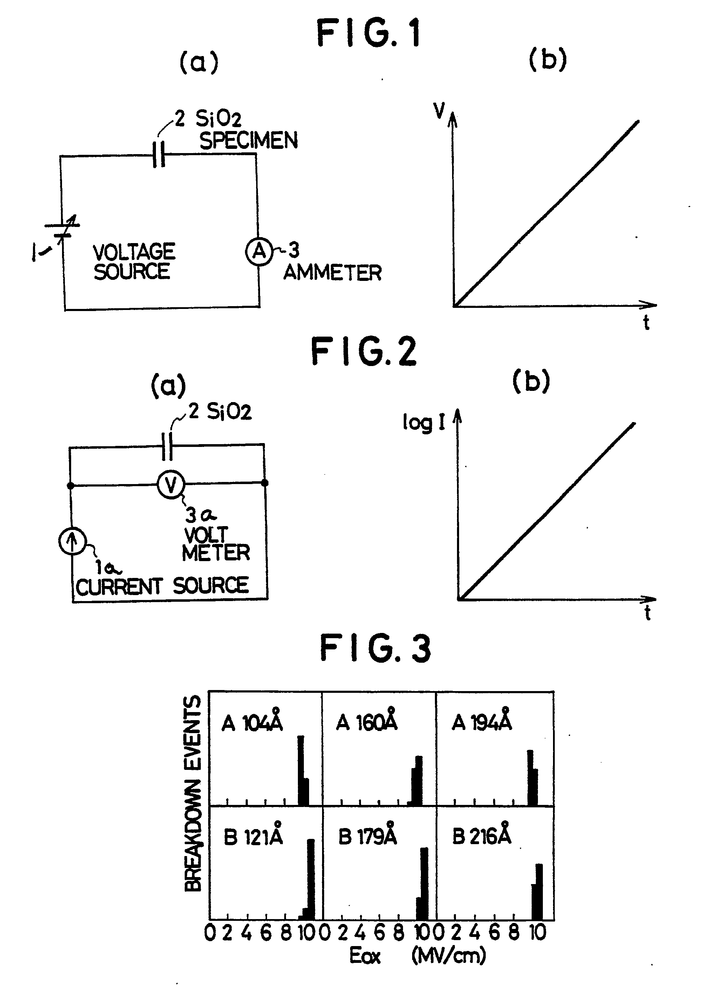

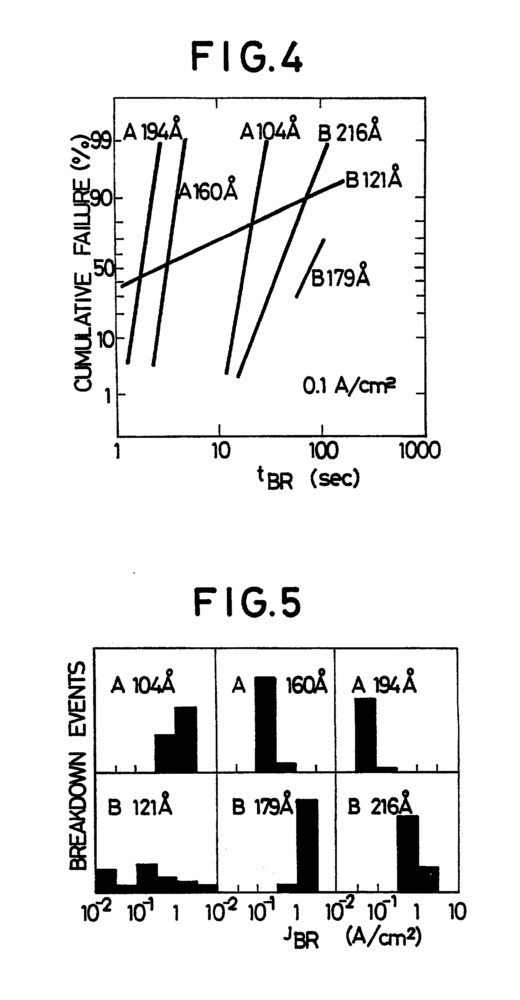

Reference will first be made to Figures 3 and 4 which respectively relate to the "voltage ramping method and the constant-current TDDB method referred to above.

Figure 3 comprises a number of graphs which illustrate the variations in the insulating strength of various $SiO_2$ films A and B, each having thicknesses of 10nm to 22nm (100 to 220 angstroms). The abscissa of each graph indicates the electric field strength $E_{ox}$ in MV/cm, and the ordinate of each graph represents the frequency of "breakdown events", i.e. the number of places where dielectric breakdown occurs. The films A and B were produced by different heat treatments. Though these films A and B have different insulating properties which were produced as a result of the different heat treatments, no difference in the electric field strength at which dielectric breakdown occurs can be recognised from Figure 3.

The TDDB method, on the other hand, is effective to evaluate the quality and reliability of the insulating films, but requires a long period of time since the time must be measured until dielectric breakdown of the film occurs.

Figure 4 illustrates the variation of the insulating strength of $SiO_2$ films A and B of various thicknesses, the insulating strength being measured by TDDB. The abscissa of Figure 4 represents the time to breakdown $t_{BR}$ of the films in seconds, and the ordinate of Figure 4 is marked to indicate both Cumulative Failure, i.e. the total percentage of films which have suffered dielectric breakdown at any particular point in time, and the current density in A/cm². The differences between the various films are clearly evident from Figure 4. Moreover, since a number of specimens must be measured to obtain statistically significant results, a considerable period of time is required.

An object of the present invention is therefore to provide a method for evaluating the breakdown time of an insulating film which enables the breakdown time to be easily measured.

Figures 1 and 2 therefore illustrate the principle of using the breakdown current density to evaluate the insulating properties of an insulating film in accordance with the present invention. Figure 1 illustrates a "voltage ramping" method similar to that employed in a known method of testing insulating strength. As shown in Figure 1(a) an $SiO_2$ specimen 2 is connected by electrodes (not shown) in a simple circuit which merely comprises a variable voltage source 1 and an ammeter 3. Thus when this "voltage ramping" method is employed, there is no need to provide any extra device, as will be clear from the circuit diagram of Figure 1(a). In the case of this "voltage ramping" method, the voltage V applied to the insulating film is, as shown in Figure 1(b), plotted against time $t$ so as to monitor the current that flows, and the value of the current just before it increases abruptly as a result of the rupture of the film is determined as being the breakdown current. Generally, the breakdown current is converted into a current density in accordance with the effective area of the electrodes employed and a number of current densities at different areas of the specimen are measured to find the distribution thereof.

Figure 2 illustrates a "current ramping" method employed in the present invention, wherein Figure 2(a) shows a circuit therefor. In the circuit of Figure 2(a), the $SiO_2$ specimen 2 is connected across a current source 1a whose voltage is measured by a voltmeter 3a. In this case, the voltage of the insulating film is monitored while maintaining constant the logarithmic change of current with the lapse of time as shown in the graph of Figure 2(b), and the distribution of the breakdown current density is determined, the breakdown currents being the ones which occur just before the voltage decreases suddenly.

Figure 5 illustrates examples of the thus found distributions of breakdown current densities. 10nm to 22nm (100 to 220 angstroms) thick $SiO_2$ specimens were measured on the same silicon wafer as that used for finding the distributions of insulating strength of Figure 3. In Figure 5, the abscissa represents the current density of the breakdown current (in A/cm²) and the ordinate represents the frequency of the "breakdown events", i.e. the number of places where dielectric breakdown occurs. Symbols A and B represent differences in the thermal history of the silicon wafers in the course of the formation of the $SiO_2$. Figure 5 clearly indicates differences in the film qualities that cannot be determined by the "voltage ramping" method of Figure 3, Figure 5 giving results similar to those given by the characteristics of Figure 4. That is to say, it can be recognised in Figure 5 how the results depend upon the differences in the thermal histories of the films A, B, the film thickness, and abnormal distributions in the case of B 12.1 nm (121 Å). It will be understood from Figures 4 and 5 that to find the distributions of breakdown current densities is as easy as in the known "voltage ramping" method, yet it is possible to evaluate the film qualities more minutely than the known "voltage ramping" method.

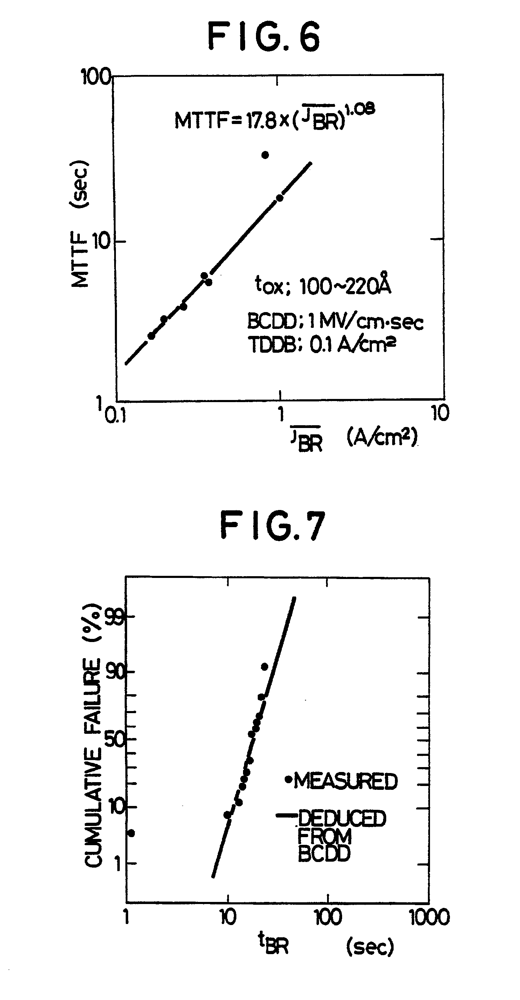

In order to deduce the breakdown time which is the most effective characteristic for evaluating insulating films, it is necessary to translate the breakdown current densities into the breakdown time. The translation makes use of a correlation between an MTTF (mean time to failure, i.e. mean time between failures) of the constant-current TDDB and an average value of distributions of the breakdown current densities of $SiO_2$ films formed from the same silicon wafer. Figure 6 shows the correlation, the abscissa of the graph of Figure 6 representing the breakdown current density (in A/cm²), and the ordinate thereof representing the MTTF (in seconds). The constant-current TDDB was measured when the current density was 0.1 mA/cm², and the distribution of breakdown current densities was measured by the "voltage ramping" method when the electric field strength was 1 MV/cmsec. These two values show a very intimate correlation which is given by $(MTTF) = \overline{17.8} \times (J_{BR})^{1.08}$ ............(1)
where $\overline{J_{BR}}$ represents the mean value of the distributions of breakdown current densities.

The equation (1) represents a correlation between the TDDB and the mean value of the distributions of breakdown current densities. Both of them are based upon breakdown testing, and it is not therefore possible to conduct these measurements using the same specimen. However, if it were possible, these measurements would correspond to each other in a one-to-one manner. Accordingly, the equation (1) can be written as,
$(TTF) = 17.8 \times (J_{BR})^{1.08}$ ........ ........(2)
where (TTF) represents the time until the breakdown takes place.

The value 17.8 in the equations (1) and (2) depends upon the conditions of these measurements.

In Figure 7, the abscissa represents the time to breakdown in seconds, and the ordinate represents "Cumulative Failure", i.e. the percentage of films which have suffered dielectric breakdown at any particular point in time. Figure 7 shows the constant-current TDDB deduced from the distribution of breakdown current densities in accordance with the equation (2) in comparison with the practical constant-current TDDB, wherein the dots represent practically found values and the lines represent values deduced from the distributions of breakdown current densities. These values are in good agreement. Thus, finding the distribution of breakdown current densities makes it possible to deduce the breakdown time which in turn enables the quality and reliability of the insulating film to be exactly determined without requiring the lengthy periods of time which are required in the constant-current TDDB method.

Thus the present invention, which provides a method for evaluating an insulating film by finding the distribution of the breakdown current density of the film, is as simple as the known method for finding the distribution of the insulating strength, yet makes it possible to evaluate the film quality of the insulating film more accurately. Further, the method of the present invention makes it possible to deduce the breakdown time of the insulating film accurately without requiring a long period of time.

The present invention may be summed up in the following way.

An insulating film constitutes a component of an IC (Integrated Circuit). Its quality has a considerable effect on the yield rate of ICs, but varies according to the wafers or lots concerned. Accordingly, only acceptable wafers or lots can be sent to the next process after evaluating the quality of the insulating film per unit of the wafers or lots. The quality of the insulating film can be proved through the evaluation of the test patterns of the insulating film in the ICs. If a test pattern of the wafers or lots indicates a low rate of acceptability, the yield rate of the ICs is low.

The present invention discloses one method for evaluating the test patterns. In the present invention, the quality of the insulation film is evaluated according to the distribution of the breakdown current densities. The distribution can be easily measured. Moreover, TDDB data, which may be obtained by the conventional evaluation method, can be estimated by calculating the said distribution.

As regards the calculation of TDDB through the distribution of the breakdown current densities, the measurement of the distribution of the breakdown current densities may be effected, for example, as follows. About one hundred evaluation patterns of an insulating film may be prepared in a wafer. Half the samples of the patterns may be evaluated for the distribution of the breakdown current densities. For the other wafers, the above evaluation may be conducted in the same way. As a result, a mean value of the breakdown current density may be obtained for every wafer as indicated in Figure 5.

As regards the evaluation through TDDB, for the remaining samples which are not employed for the distribution of the breakdown current densities, TDDB data may be obtained and the time taken for half of the samples employed in TDDB to breakdown may be determined. This experiment may be conducted for all wafers, as indicated in Figure 4.

In order to clarify the correlation between the breakdown current density and TDDB, a graph may be made in which the mean values of the breakdown current are shown on the horizontal axis, the breakdown time for 50% of samples through TDDB being shown on the vertical axis (Figure 6).

Breakdown current densities of the insulation film may be measured. From the densities, the breakdown time of TDDB may be estimated by use of the correlation graph. This may be conducted for the plurality of samples so that a breakdown rate at a certain time can be obtained (Figure 7).

After the above, in evaluating other samples, the time to failure can be estimated from Figure 6 by obtaining the values of the breakdown current density. Also, cumulative failure rate can be estimated from Figures 6 and 7. Since both estimations are made by the use of the breakdown current densities, they can be made for a shorter period of time than in the conventional TDDB method.

In the method now in use for obtaining the breakdown current density, a voltage sweep is applied to the film in a series of steps which are equally spaced apart in the and at each of which the voltage is increased by the same amount. A current reading is made at each step. When the current value at one particular step becomes twice or more that of the preceding step, the current of the preceding step is regarded as the breakdown current. It is known from experience that a permanent breakdown occurs when a value becomes twice or more the preceding value. However, the point of the occurrence varies according to the voltage step.

In the conventional technique, the dielectric distribution does not necessarily break down all the films permanently. That is, a film which passes a certain point of time (a certain value of the voltage or current in the voltage sweep) is considered to be acceptable. On the other hand, the present invention is to sub-rank the acceptable films so that all the films for evaluation provided in several places in a wafer can be permanently broken down. This is an important feature of the present invention that distinguishes it from the conventional method. Moreover, it is found that the current distribution of the permanent breakdown has a correlation with the distribution of TDDB. If the correlation is previously obtained and the value of the breakdown current density of the insulation films for evaluation is known, the result of TDDB can be estimated by applying the value of the breakdown current density to the correlation. It is a merit of the present invention that the result of TDDB can be estimated in a shorter time than in the known time-consuming TDDB method.

**Claims**

1. A method of evaluating the breakdown time of an insulating film comprising causing a current to flow through said film characterised by determining the distribution of the breakdown current density in the film, making a correlation between the said distribution and the mean time between failures of a constant-current Time Dependent Dielectric Breakdown, and finding the breakdown time of said insulating film by means of said correlation.

2. A method as claimed in claim 1 characterised in that the current is caused to flow by applying a gradually increased voltage to the film.

3. A method as claimed in claim 1 or 2 characterised in that the breakdown current density is deduced by monitoring the current through the insulating film so as to determine the point at which the current is about to increase abruptly.

4. A method as claimed in claim 1 characterised in that the current is gradually increased in a logarithmic manner.

5. A method as claimed in claim 1 or 4 characterised in that the breakdown current density is deduced by monitoring the voltage across the film so as to determine the point at which the voltage is about to decrease abruptly.

## Patentansprüche

1. Verfahren zur Bestimmung der Zeit bis zum elektrischen Spannungsdurchbruch einer isolierenden Schicht, bei dem ein Strom durch die Schicht geschickt wird, dadurch gekennzeichnet, daß die Verteilung der Durchbruchsstromdichte in der Schicht bestimmt wird, daß zwischen der Verteilung und der mittleren Zeit zwischen Ausfällen in Form eines zeitabhängigen dielektrischen Konstantstromdurchbruchs eine Korrelation hergestellt wird und daß die Durchbruchszeit der isolierenden Schicht mit Hilfe der Korrelation ermittelt wird.

2. Verfahren nach Anspruch 1, dadurch gekennzeichnet, daß der Stromfluß durch Anlegen einer graduell zunehmenden Spannung an den Film erzeugt wird.

3. Verfahren nach Anspruch 1 oder 2, dadurch gekennzeichnet, daß die Durchbruchsstromdichte durch Überwachung des durch die isolierende Schicht fließenden Stroms ermittelt wird, um den Punkt zu bestimmen, in dem der Strom abrupt zuzunehmen beginnt.

4. Verfahren nach Anspruch 1, dadurch gekennzeichnet, daß der Strom graduell logarithmisch erhöht wird.

5. Verfahren nach Anspruch 1 oder 4, dadurch gekennzeichnet, daß die Durchbruchsstromdichte durch Überwachung der Spannung an der Schicht ermittelt wird, um den Punkt zu bestimmen, in dem die Spannung abrupt abzunehmen beginnt.

## Revendications

1. Un procédé d'évaluation du temps de claquage d'un film isolant dans lequel on fait circuler un courant à travers le film, caractérisé en ce qu'on détermine la distribution de la densité de courant de claquage dans le film, on établit une corrélation entre cette distribution et le temps moyen entre défaillances dans un procédé de Claquage Diélectrique Dépendant du Temps à courant constant, et on détermine le temps de claquage du film isolant au moyen de cette correlation.

2. Un procédé selon la revendication 1, caractérisé en ce qu'on fait circuler le courant en appliquant au film une tension qui augmente progressivement.

3. Un procédé selon la revendication 1 ou 2, caractérisé en ce qu'on détermine la densité de courant de claquage en contrôlant le courant qui traverse le film isolant de façon à déterminer le point auquel le courant va augmenter de façon abrupte.

4. Un procédé selon la revendication 1, caractérisé en ce qu'on augmente le courant progressivement, d'une manière logarithmique.

5. Un procédé selon la revendication 1 ou 4, caractérisé en ce qu'on détermine la densité de courant de claquage en contrôlant la tension de part et d'autre du film afin de déterminer le point auquel la tension va diminuer de façon abrupte.

# FIG.1

(a)  (b)

2 SiO2 SPECIMEN

VOLTAGE SOURCE

A ~3 AMMETER

# FIG.2

(a)  (b)

2 SiO2

3a VOLT METER

1a CURRENT SOURCE

# FIG.3

BREAKDOWN EVENTS

A 104Å  A 160Å  A 194Å

B 121Å  B 179Å  B 216Å

0 2 4 6 8 10  0 2 4 6 8 10  0 2 4 6 8 10

Eox (MV/cm)

# FIG.4

# FIG.5

EP 0 219 266 B1

# FIG. 6

$$MTTF = 17.8 \times (\overline{J}_{BR})^{1.08}$$

MTTF (sec)

$t_{ox}$; 100~220Å

BCDD; 1 MV/cm·sec
TDDB; 0.1 A/cm²

$\overline{J}_{BR}$ (A/cm²)

# FIG. 7

CUMULATIVE FAILURE (%)

• MEASURED

— DEDUCED
FROM
BCDD

$t_{BR}$ (sec)